# EUROPEAN PATENT APPLICATION

(11) **EP 1 724 813 A1**
(43) Date of publication of application: **22.11.2006**
(21) Application number: 05710099.2
(22) Date of filing: 10.02.2005
(51) Int. Cl.: H01L 21/02, G03F 1/08, G03F 1/16, G06F 17/50, H01L 21/027, H01L 21/82

(54) **INTEGRATED CIRCUIT DESIGN METHOD, DESIGN SUPPORT PROGRAM USED IN THE INTEGRATED CIRCUIT DESIGN METHOD, AND INTEGRATED CIRCUIT DESIGN SYSTEM**

(30) Priority: 10.02.2004 JP 2004033943
(71) Applicant: Japan Science and Technology Agency, Kawaguchi-shi, Saitama 332-0012 (JP)
(72) Inventor: KAWAMOTO, Hiroshi, 8113425 (JP)
(74) Representative: Klunker . Schmitt-Nilson . Hirsch
(86) International application number: PCT/JP2005/002047
(87) International publication number: WO 2005/076320

(57) **Abstract**

[PROBLEMS] To provide an integrated circuit design method realized as a photomask/photomaskless fusion method wherein a photomask trial method and a photomaskless trial method are fused with each other so as to obtain both a merit of the photomask trial method allowing production of trial chips without producing photomasks and a merit of the photomaskless trial method allowing use of pattern information for a trial production as pattern information for a mass production trial. To provide a design assistance program and an integrated circuit design system used in such an integrated circuit design method. [SOLVING MEANS] A trial integrated circuit is produced based on pattern information for a trial production, without using a photomask, under a common design circumstance which can be utilized in both a photomaskless step of producing an integrated circuit based on pattern information without using a photomask and a photomask step of producing an integrated circuit based on pattern information with using a photomask, with the pattern information for the trial production complying with both the photomaskless step and the photomask step. A common pattern information is prepared by evaluating the trial integrated circuit and by modifying the pattern information for the trial production in accordance with results of the evaluation, if necessary, without being modified. A photomask for a mass production is produced by carrying out a formal conversion of the common pattern information, if necessary.

## Description

### TECHNICAL FIELD

The present invention relates to an integrated circuit design method, especially such an integrated circuit design method in a layout/pattern design, and relates to a design assistance program regarding such an integrated circuit design method, and an integrated circuit design system regarding such an integrated circuit design method.

### BACKGROUND OF ART

A design of an integrated circuit includes a function design, a logic design and a layout/pattern design. In the function design, functions to be incorporated in the integrated circuit are determined, and pieces of function design information on a function specification document and so on are prepared in a predetermined description manner (function diagrams, hardware description language (HDL), logic equations, truth-value tables, program lists using the C language or the like). Based on these prepared pieces of function specification information, in the logic design, pieces of logic design information, such as net lists indicating connection relationships among transistors blocks and so on, are prepared taking semiconductor techniques into consideration. Then, in the layout/pattern design, pieces of pattern information for mass production are prepared based on the prepared pieces of logic information. In the layout/pattern design, for the purpose of producing photomask patterns for the mass production, trial chips are produced, and the produced trial chips are analyzed and evaluated. There are two design methods, which are different from each other whether or not a photomask is used in the trial-chip production. When the photomask is used, it is called a photomask trial method, and, when no photomask is used, it is called a photomaskless trial method.

In the former photomask trial method, pieces of pattern information for the trial-chip production are prepared based on the pieces of logic design information, a photomask is produced based on the prepared pieces of pattern information, and the trial chips are produced. Then, the trial chips thus produced are evaluated. When the evaluated results show that desirable characteristics and a desirable yield rate cannot be obtained, the design is started afresh, and pieces of pattern information are again prepared. The design is repeatedly carried out until the evaluated results show that the desirable characteristics and the desirable yield rate can be obtained.

In the latter photomaskless trial method, pieces of pattern information for the trial-chip production are prepared based on the pieces of logic design information, the trail chips are produced based on the prepared pieces of pattern information without producing a photomask. Then, the trial chips thus produced are evaluated. When the evaluated results show that desirable characteristics and a desirable yield rate cannot be obtained, the design is started afresh, and pieces of pattern information are again prepared. The design is repeatedly carried out until the evaluated results show that the desirable characteristics and the desirable yield rate can be obtained. Various methods for producing the trial chips without producing the photomask have been proposed. For example, the production of the trial chips is carried out by using an electron beam direct drawing apparatus. The photomaskless trial method has advantages that there is no need of the photomask upon producing the trial chips, and that no cost of expensive photomasks is involved although an alternation of the design is repeated over and over again. Thus, the photomaskless trial method is expected as a solution of the rising cost of the photomasks in a trend toward the miniaturization.

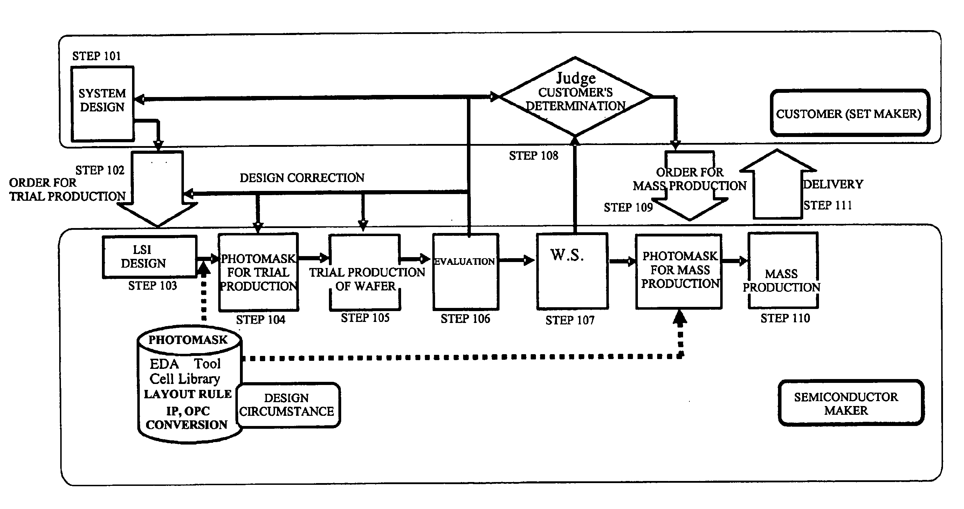

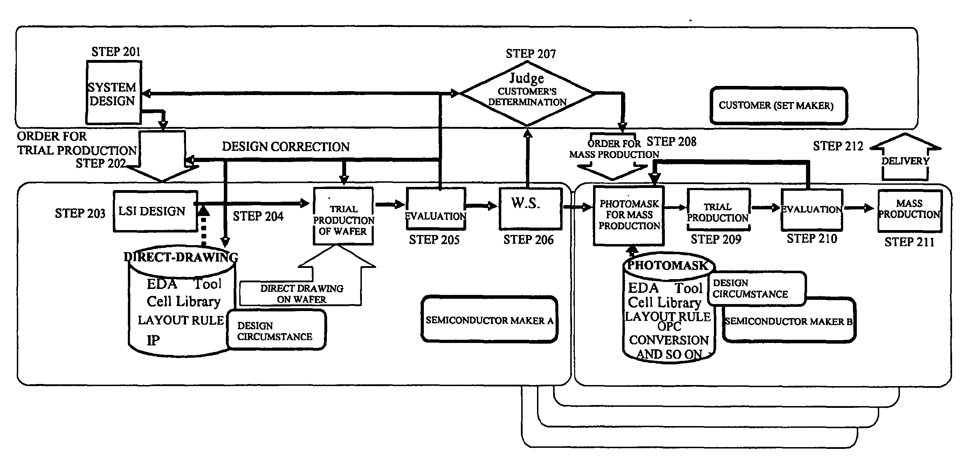

Note, respective development flowcharts using the photomask trial method and the photomaskless trial method are shown in Figs. 11 and 12. In the development flowchart using the photomask trial method, a system design (step 101) is carried out by a customer (set maker), and an order for trial-chips with a design document is given to a semiconductor maker (step 102). Customers or customer's products have different stages to which the system designs progress. There may be a case where the aforesaid logic design is completed, there may be a case where only the function design is completed, and there may be a case where only required specifications are determined. Thus, different design documents are given to the semiconductor maker. In the semiconductor maker by which a design document is received, an LSI design is carried out based on the design document, using design tools, such as an EDA software, a cell library, a layout rule, an IP and so on, which constitute a design circumstance of the photomask trial method, to thereby prepare pieces of pattern information (step 103). A trial photomask is produced based on the pieces of pattern information, using a photomask producing apparatus (step 104). The trial photomask is set in an optical exposure apparatus, and trial chips are produced on a wafer (step 105). Various evaluations are carried out with respect to the trial chips (step 106). When the evaluated results do not satisfy requirements of the specifications, such as a characteristic, a yield rate and so on, the flow returns to the step which causes this failure. When the evaluated results satisfy the requirements of the specifications, a WS (working sample) is delivered to the customer (set maker) from the semiconductor maker (step 107), and the customer (set maker) evaluates the WS (step 108). As the result of the evaluation, when it is determined by the customer (set maker) that an alteration is required, the flow proceeds to the customer system design in which an order for trial-chips is again given. As the result of the evaluation, when it is determined by the customer (set maker) that no alteration is required, an order for mass production is given to the semiconductor maker (step 109), and the mass production is carried out by the semiconductor maker, using a mass-production photomask which is identical to the trial photomask from which the order for mass production is derived (step 110). After products are manufactured, these products are delivered to the customer (set maker) (step 111).

In the development flowchart using the photomaskless trial method, a system design (step 201) is carried out by a customer (set maker), and an order for trial-chips with a design document is given to a semiconductor maker (step 202). In the semiconductor maker by which the design document is received, an LSI design is carried out based on the design document, using design tools, such as an EDA software, a cell library, a layout rule, an IP and so on, which form a design circumstance of the photomaskless trial method (when an electron beam direct drawing apparatus is used to produce trial chips, a direct drawing design circumstance is made as shown in Fig. 12. A case where the electron beam direct drawing apparatus forming an example of the photomaskless trial method is used, is explained below.), to thereby prepare pieces of pattern information (step 203), and a direct drawing is carried out based on the pieces of pattern information, to thereby produce trial chips on a wafer (step 204). Various evaluations are carried out with respect to the trial chips (step 205). When the evaluated results do not satisfy requirements of the specifications, such as a characteristic, a yield rate and so on, the flow returns to the step which causes this failure. When the evaluated results satisfy the requirements of the specifications, a WS (working sample) is delivered to the customer (set maker) from the semiconductor maker (step 206), and the customer (set maker) evaluates the WS (step 207). As the result of the evaluation, when it is determined by the customer (set maker) that an alteration is required, the flow proceeds to the customer system design in which an order for trial-chips is again given. As the result of the evaluation, when it is determined by the customer (set maker) that no alteration is required, an order for mass production is given to the semiconductor maker (step 208). In the semiconductor maker, by using EDA tools, a cell library, a layout rule, an IP and so on, which form a design circumstance of the photomask trial method, a mass-produotion trial photomask is produced based on the pieces of pattern information from which the order for mass production is derived (step 209). This trial photomask is set in an optical exposure apparatus, trial chips are produced on a wafer, and various evaluations are carried out with respect to these trial chips (step 210). As the result of the evaluations, when the produced trial chips are not identical to the trial chips produced by the aforesaid electron beam direct drawing apparatus, the pieces of pattern information or the trial photomask are subjected to alterations. As the result of the evaluations, when the produced trial chips are identical to the trial chips produced by the aforesaid electron beam direct drawing apparatus. The mass production is carried out by the semiconductor maker, using a mass-production photomask which is identical to the trial photomask (step 211). After products are manufactured, these products are delivered to the customer (set maker) (step 212).

### DISCLOSURE OF THE INVENTION

### PROBLEMS TO BE RESOLVED BY THE INVENTION

In the photomaskless trial method as stated in the above-mentioned background, surely, since no cost for the photomasks is needed during the trial production, it is possible to reduce the design cost, on the whole, in comparison with the photomask trial method. However, during the trial production, the trial chips are produced without using directly any photomasks, and thus no evaluations can be obtained when using the photomasks. Namely, there is a case where the chips obtained during the trial production is out of accord with the chips obtained during the mass production. Before the pieces of pattern information can be used as the pieces of pattern information for the mass production, a step of producing the chips based on the actual pieces of pattern information and a step of evaluating the produced chips have to be repeatedly carried out until the desirable characteristics and the desirable yield rate are obtained. Thus, there are problems that the expected advantages cannot be necessarily obtained in the aspects of the production cost and the development period. For example, during the trial production, the chips are produced based on the pieces of pattern information, using the electron beam direct drawing apparatus, without producing any photomasks, and evaluations of the produced chips carried out to thereby complete the pieces of pattern information. Then, the photomasks are actually produced based on the completed pieces of pattern information, the chips are produced by using the optical exposure apparatus, and the produced chips are evaluated to thereby prepare the pieces of pattern information for the mass production. Thus, due to a difference between characteristics of the electron beam direct drawing apparatus and characteristics of the optical exposure apparatus, in addition to the pieces of pattern information for the trial production, it is necessary to additionally prepare the pieces of pattern information for the mass production by improving the pieces of pattern information for the trial production. In this case, if the pieces of pattern information for the trial production can be formally converted into the pieces of pattern information for the mass production, there is no problem because the conversion can be carried out without intervention of a designer. However, when characteristics of the apparatus for producing the trial chips are different from those of the apparatus for carrying out the mass production of chips, and when the pieces of pattern information for the trial production are prepared, taking into account only the characteristics of the apparatus for producing the trial chips, it is difficult to mechanically convert that pieces of pattern information into the pieces of pattern information which should be taken into account the characteristics of the apparatus for carrying out the mass production of chips. producing the trial chips. Note, in the photomask trail method, the photomasks are prepared in the trial production, and have the patterns for producing the mass production photomasks, and thus the photomask patterns for trial production can be used for the mass production photomask patterns as they stand.

The present invention has been achieved to resolve the above-mentioned problems, and an object of the present invention is to provide an integrated circuit design method, which can be realized as a photomask/photomaskless fusion method wherein a photomask trial method and a photomaskless trial method are fused with each other so as to obtain both a merit of the photomask trial method allowing production of trial chips without producing photomasks and a merit of the photomaskless trial method allowing use of pieces of pattern information for a trial production as pieces of pattern information for a mass production trial, a design assistance program using such an integrated circuit design method, and an integrated circuit design system using such an integrated circuit design method.

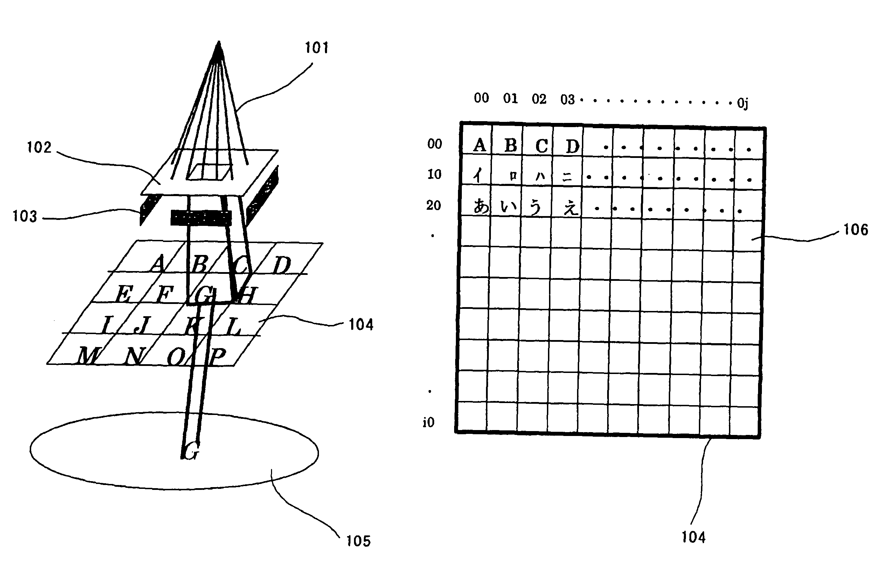

Also, regarding the present invention, in a direct drawing apparatus which is a photomaskless apparatus, a direct exposure is carried out such that a pattern is drawn in a single stroke scanning manner with a fine electron beam (0.01 to 0.1 µm) to thereby allow a free pattern drawing, but there is a problem that it takes a long time for the drawing. Concretely, more than 10 hours per a wafer, which are from 10 to 100 times in comparison with an exposure mask method, are needed. As a countermeasure against this, a method for Incorporating a block mask in the direct drawing apparatus is utilized, with a plurality of patterns (cells and so on), which have a high frequency in use, being formed as blocks in the block mask. In Fig. 13, a drive explanatory view of the direct drawing apparatus and a front view of the block mask are shown.

Based on Fig. 12, an emitted electron beam is shaped into a beam, having a block size (5[µm]×5[µm] in this drawing), through the intermediary of a slit 102, and a pattern, which is formed in a given block Pᵢⱼ, is projected on a wafer through the given block Pᵢⱼ.

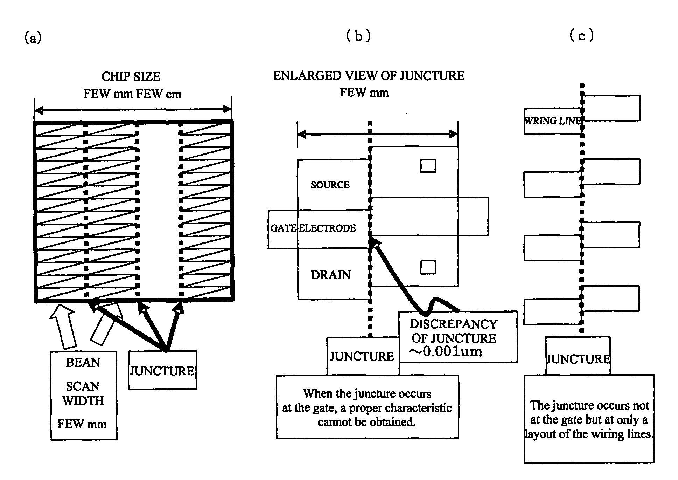

In the block mask, from about 20 to about 1000 kinds of pattern 106 (cell) are arranged in the same dimension. A random pattern 106, which is defined as a cell, also has the same dimension. However, when a rectangular random pattern, which is defined as a wiring pattern in a router (wiring software), is divided into a plurality of blocks, in this same-dimension block method, a block projection must be repeatedly carried out before the wiring pattern can be drawn, and thus this is very inefficient. In Fig. 4, an LSI wiring pattern is shown in a partial front view.

Therefore, an object of the present invention is also to provide an significant block mask and a maskless apparatus per se, which are utilized in the integrated circuit design method, the design assistance program using the integrated circuit design method, and the integrated circuit design system using the integrated circuit design method.

### MEANS FOR SOLVING THE PROBLEMS

In an integrated circuit production method according to the present invention, a trial integrated circuit is produced based on pattern information for a trial production, without using a photomask, under a common design circumstance which can be utilized in both a photomaskless step of producing an integrated circuit based on pattern information without using a photomask and a photomask step of producing an integrated circuit based on pattern information with using a photomask, with the pattern information for the trial production complying with both the photomaskless step and the photomask step. A common pattern information is prepared by evaluating the trial integrated circuit and by improving, if necessary, the pattern information for the trial production in accordance with results of the evaluation, and a photomask for a mass production is produced by carrying out a formal conversion of the common pattern information, if necessary, without improving the common pattern information. In this method, the formal conversion is defined as a conversion in which an identity on a finally produced chip is maintained, and is different from a conversion in which an identity on a finally produced chip is not maintained. Concretely, the formal conversion may be a file form conversion, and an OPC processing is the formal conversion, as stated hereinafter. Also, after the trial integrated circuit is produced, when there is an customer's demand, the common pattern information is modified in accordance with the customer's demand. Then, the modified common pattern information is stored as a common pattern, and a trial integrated circuit is again delivered to the customer. In each of the photomaskless step and the photomask step, a drawing process includes several tens of steps. In even the photomaskless step, an electron beam direct drawing apparatus is utilized to carry out a drawing process in a step of forming a complicatedly multi-layered section of a semiconductor device, and an optical exposure apparatus is utilized to carry out a drawing process in another step. Although the present invention is occasionally referred to as an integrated circuit design method herein, there is an area in which the integrated circuit design method and the integrated circuit production method cannot be distinguished from each other, and thus there may be a case where the design method implies the production method. In this paragraph, although the present invention is referred to as the integrated circuit production method, more particularly, it may be defined as the integrated circuit design method in the course of the production.

Also, in the integrated circuit production method according to the present invention, if necessary, the common design circumstance is constituted as a design circumstance, including design tools, such as, an EDA (electronic design automation) software, an inspection software, a cell library, IP (intellectual property), an OPC (optical and process correction) processing software and so on necessary for an integrated circuit production, so as to be commonly utilized in both the photomaskless step and the photomask step. In this paragraph, although the present invention is referred to as the integrated circuit production method, more particularly, it may be defined as the integrated circuit design method in the course of the production.

Also, in the integrated circuit production method according to the present invention, if necessary, the trial integrated circuit is produced on the same wafer based on the pattern information which is featured by different integrated circuits, integrated circuits having the same functions and parameters for requirements, or a combination of some of these integrated circuits, without using the photomask. In this paragraph, although the present invention is referred to as the integrated circuit production method, more particularly, it may be defined as the integrated circuit design method in the course of the production.

Also, in the integrated circuit production method according to the present invention, a mass production of chips is carried out by the photomask apparatus, using a photomask which is produced based on pieces of common pattern information which are concerned with respective chips assigned on the same wafer in accordance with external demands. In this method, each of the external demands is mainly a set maker's order for mass production, and the order for mass production may be carried out on an electrical communication network. It is desirable to construct a system in which the mass production can be automatically carried out as soon as the order for mass production is accepted.

In an integrated circuit design assistance program according to the present invention, a computer functions as a conversion means for converting design information, prepared through the intermediary of an integration circuit function design and/or a logic design, into pattern information which satisfies both a pattern characteristic of a photomaskless apparatus for producing an integrated circuit based on pattern information without using a photomask and a pattern characteristic of a photomask apparatus for producing an integrated circuit by using a photomask based on pattern information. Like this, in the present invention, since the conversion means converts the prepared design information into the pattern information, which satisfies both the pattern characteristic of the photomaskless apparatus and the pattern characteristic of the photomask apparatus, it is possible to utilize the same pieces of pattern information in both the photomaskless apparatus and the photomask apparatus. Also, even though the pieces of pattern information are formally different from each other, respective chips produced on wafers are at least finally identical to each other. Accordingly, the pattern information can be utilized, as it is, in an integrated circuit development using only the photomaskless apparatus, an integrated circuit development using only the photomask apparatus, and an integrated circuit development using both the photomaskless apparatus and the photomask apparatus 20, and thus it is possible to utilize various development methods. The photomaskless apparatus may concretely comprise an electron beam direct drawing apparatus, and the photomask apparatus may concretely comprise an optical exposure apparatus.

Also, in the integrated circuit design assistance program according to the present invention, the conversion means carries out the conversion of the design information into the pattern information by using a cell library, which comprises a congregation composed of pattern components which satisfies both the pattern characteristic of the photomaskless apparatus and the pattern characteristic of the photomask apparatus. Like this, in the present invention, since the conversion of the pattern information is carried out by the conversion means, using the common cell library comprising the congregation composed of pattern components which satisfies both the pattern characteristic of the photomaskless apparatus and the pattern characteristic of the photomask apparatus, the pattern information of the photomaskless apparatus and the pattern information of the photomask apparatus are substantially identical to each other, and thus the chips produced by the photomaskless apparatus and photomask apparatuses may be identical to each other. Especially, when the photomaskless apparatus is the electron beam direct drawing apparatus, the design information is converted into the pattern information by using the common cell library, and thus it is possible to frequently utilize a block exposure, resulting in the improvement of the throughput.

Also, an integrated circuit design system according to the present invention is constituted by an integrated circuit design assistance apparatus obtained by installing the aforesaid integrated circuit design assistance program in a computer, the aforesaid photomaskless apparatus, and the aforesaid photomask apparatus, if necessary. The integrated circuit design assistance apparatus outputs either pattern information or similar pattern information, allowed to be input to the photomaskless apparatus, to the photomaskless apparatus, and the photomaskless apparatus produces a trial integrated circuit based on either the pattern information or the similar pattern information. The trial integrated circuit is evaluated to prepare common pattern information, with the common pattern information being improved, if necessary, and a mass production of chips is carried out by the photomask apparatus, using a photomask based on the common pattern information. Like this, in the present invention, the integrated circuit design assistance apparatus outputs either the pattern information or the similar pattern information to the photomaskless apparatus, and the photomaskless apparatus produces a trial integrated circuit based on the pattern information. Then, the trial integrated circuit is evaluated, and the common pattern information is improved, if necessary. Then, the mass production of chips is carried out by the photomask apparatus, using the photomask produced based on the improved common pattern information. Thus, the trial integrated circuit is produced at low cost by using the photomaskless apparatus 20 without using an expensive photomask, and is improved, if necessary, to thereby produce the trial integrated circuit which satisfies the requirements of the specifications. When the order for mass production is given, a photomask is produced without any evaluations, by only carrying out the conversion of the pattern information, from which the trial integrated circuit satisfying the requirements of the specifications is derived, and thus it is possible to immediately carry out the mass production. Usually, although it is necessary to carry out respective evaluations at a trial production stage and a mass production stage upon using the photomask apparatus, these evaluations are unnecessary, and thus not only can the production cost be considerably reduced, but also the development period can be shortened.

Also, in the integrated circuit design system according to the present invention, if necessary, the conversion means carries out the conversion of the design information into the pattern information so that a juncture, caused by a width of an electron beam of an electron beam direct drawing apparatus, departs from an active area. Like this, in the present embodiment, the conversion means carries out the conversion of the pattern information so that the juncture, caused by the width of the electron beam of the electron beam direct drawing apparatus, departs from the active area. Thus, although the pattern information concerned is subjected to the juncture processing, which is unnecessary for the photomask apparatus, not only can the chips be inexpensively produced by the photomaskless apparatus, but also the photomask can be produced based on the pattern information which is derived from the well-evaluated chip. Accordingly, it is possible to immediately carry out the mass production, using the aforesaid photomask as it is. Thus, not only can the production cost be reduced, but also the development period can be shortened.

Also, in the integrated circuit design system according to the present invention, if necessary, the conversion means further converts the converted pattern information into pattern information subjected to an OPC processing for the photomask apparatus. Like this, in the present invention, since the pattern information converted by the conversion means is further converted into the OPC processed pattern information for the purpose of the photomask apparatus, the OPC processed pattern information is not identical to the pattern information which is derived from the well-evaluated chip. Nevertheless, since the chip, which is produced by using the photomask produced based on the OPC processed pattern information, is identical to the well-evaluated chip, it is possible to carry out the mass production without any evaluations.

Also, in the integrated circuit design system according to the present invention, if necessary, the photomaskless apparatus produces trial integrated circuits on the same wafer based on either pieces of pattern information or similar pieces of pattern information allowed to be input to the photomaskless apparatus. Like this, in the present invention, since the photomaskless apparatus produces the trial chips on the same wafer based on the pieces of pattern information without using any photomask, it is possible to produce plural kinds of chips on the same wafer by the photomaskless apparatus. Namely, since plural kinds of chips, which are allocated for some manufactures, can be formed on the expensive wafer, it is possible to decrease a chip production cost.

Also, in the integrated circuit design system according to the present invention, if necessary, the mass production of the chips is carried out by the photomask apparatus, using the photomask which are produced based on pieces of common pattern information which are concerned with respective chips assigned on the same wafer in accordance with external demands. Like this, in the present invention, since the mass production of the chips is carried out by the photomask apparatus, using the photomask produced based on the pieces of common pattern information which are concerned with the respective chips assigned on the same wafer in accordance with the external demands, as long as the pieces of pattern information are prepared, it is possible to automatically carry out the mass production of desirable chips in accordance with the external demands without being substantially assisted by persons. The external demands may be made in terminals which are connected to the integrated circuit design system through the intermediary of the network. When the integrated circuit design system accepts the external demands, it is possible to immediately carry out the mass production without an intervention of a person, resulting in improvement of the throughput. Each of the external demands may include not only specifications of an integrated circuit to be produced but also an origin of the external demand concerned, a number of chips to be produced, a period of production, a delivery place of chips and a price of chips. More preferably, a status of production is dispatched from the integrated circuit design system to an corresponding terminal in real time. Also, a time, counted from a time point at which the trial integrated circuit is completed by the photomaskless apparatus, may be report on occasion to the terminal concerned, resulting in promotion of external demands. Also, a possible increase in production may be reported to the terminals based on a performance of the photomask apparatus. Although the terminals are possessed by the customers, it is preferable that the system side is provided with a piece of equipment (e.g. a terminal, a display connected to the system) for the system side's recognition.

Also, a block mask according to the present invention is used in a block exposure carried out by a photomaskless apparatus, and is formed with a plurality of blocks, sides of which have different lengths. Like this, in the present invention, the block mask is different from a conventional block mask having only blocks which are formed as square blocks having the same size. For example, when the blocks are rectangular, the sides of the blocks have different lengths. Thus, it is possible to form various blocks on the block mask by freely selecting sizes of the blocks without being subjected to restrictions as the square blocks having the same size, whereby a desirable pattern can be effectively drawn by carrying out a block exposure, using the aforesaid various blocks. Note, usually, although the block has a quadrangle, it is preferable to use a rectangular block sides of which have different lengths.

Also, in the a block mask according to the present invention, when each of the blocks is shaped as a rectangular block, a long side and/or a short side of the rectangular block have lengths featured by a multiple of the minimum wiring pitch unit, if necessary. Like this, in the present invention, since each of the blocks has the rectangular shape based on the minimum wiring pitch unit, not only can the blocks be effectively formed on the block mask, but also it is easy to carry out a beam shaping and a beam scanning during the block exposure, whereby a drawing of a pattern can be rapidly executed.
Also, in the block mask according to the present invention, if necessary, the short sides of the blocks have the same length, and the long sides of the blocks have different lengths. Like this, in the present invention, since the short sides of the blocks on the block mask are unified in length, and since the long sides of the blocks have the different lengths, the beam shaping and the beam scanning can be carried out in only the longitudinal direction of the blocks, whereby the drawing of the pattern can be rapidly executed. In an actual wiring pattern, most of wiring lines have the same width, and only the lengths of the wiring lines are different from each other. Thus, the blocks can be widely utilized.

Also, in the block mask according to the present invention, if necessary, the block mask has a vertically-lengthened block area in which the blocks are arranged so that the long sides of the blocks extend in a vertical direction of the block mask, and a horizontally-lengthened block area in which the blocks are arranged so that the long sides of the blocks extend in a horizontal direction of the block mask. Like this, in the present invention, since the block mask has the vertically-lengthened block area featuring the vertical arrangement of the blocks and the horizontally-lengthened block area featuring the horizontal arrangement of the blocks, not only can the blocks be arranged at a high density in each of the vertically-lengthened block area and the horizontally-lengthened block areas, but also it is possible to easily carry out the formation of the blocks. Especially, when a diagonal line of the block mask defines a boundary between the vertically-lengthened block area and the horizontally-lengthened block area, it is possible to carry out the formation of the blocks at a higher density. Further, in an actual wiring pattern, since a semiconductor device has an area in which horizontal wiring lines are concentrated, and another area in which vertical wiring lines are concentrated, the beam shaping, the beam scanning and the block exchanging can be carried out at short time, whereby the drawing of the pattern can be rapidly executed.

Also, aphotomaskless apparatus according to the present invention is provided with a deformation means for deforming a shape of beam, which is emitted during a block exposure, into either an elongatedly rectangular shape or an elongatedly elliptic shape. Like this, in the present invention, since the photomaskless apparatus is provided with the deformation means for deforming the beam shape into the elongated shape, it is possible to efficiently carry out the block exposure by using the blocks mask which is formed with the blocks having the various sizes, with these blocks being different from the conventional block having the same size. Concretely, for example, the means for deforming the beam may be formed as a variable slit or a voltage control deflector.

Also, in the photomaskless apparatus according to the present invention, the block is scanned with the beam which is emitted during an block exposure, while a shape of the beam is maintained. Like this, in the present invention, since the beam scanning is carried out in one direction while the shape of the beam is maintained, it is possible to rapidly form a pattern. Further, in the block mask used during the block exposure, when the short sides of all the blocks have the same length, or when the block mask includes additional block masks provided that short sides of the additional blocks have a narrower width, it is possible to rapidly carry out the formation of the pattern, because the deformation means can be omitted from the photomaskless apparatus, and because it is unnecessary to use the deformation means although the photomaskless is provided with it. Nevertheless, of course, the beam scanning may be carried out by deforming the beam shape with the deformation means.

Also, in the photomaskless apparatus according to the present invention, if necessary, the block is irradiated with a plurality of beams which are arranged in a longitudinal direction of the block during the block exposure. Like this, in the present invention, since the block is irradiated with the plurality of beams, it is possible to rapidly carry out the drawing of the pattern.
Also, in the photomaskless apparatus according to the present invention, if necessary, the block is divided at regular intervals into sections at the number of beams which are longitudinally emitted, and the divided sections are irradiated and scanned with the respective beams. Like this, in the present invention, since the same block is irradiated and scanned with the plurality of beams at regular intervals, not only can a wrong drawing of a pattern be prevented due to the multi-beam irradiation, but also the beam irradiation can be carried out without wastefulness, resulting in the rapid drawing of the pattern. Although the beam scanning is usually carried out in one direction, the beam scanning may be carried out in the reverse direction (that is, when two beams are used, a block can be scanned with the beams so that the respective beams are moved from the ends of the block toward the center thereof.).

Note, the above description does not cover all the aspects of the present invention, and one of the aspects may be combined with another one to form a new aspect of the present invention.
Also, the integrated circuit production method according to the present invention comprises a step of producing cells in which pattern components corresponding to the same exposure step are identified to each other among cells of a cell library which are different from each other in a function and a capability, without exerting influence on an operation, a step of registering the produced cells in the cell library, and a step of carrying out a block exposure, using a block mask on which patterns are formed based on the cell library. Like this, in the present invention, since the pattern components corresponding to the same exposure step are identified to each other among the cells of the cell library without altering the operation, and since the patterns are formed on the block mask based on the cell library, it is possible to expose more areas by the block exposure using the block mask concerned, and thus the drawing time can be shortened. Further, by applying this block exposure using the block mask to the integrated circuit production method in which both the aforesaid photomaskless apparatus and the aforesaid photomask apparatus, it is possible to more rapidly and more efficiently produce the trial chips, and thus the mass production can be immediately carried out. In this case, although the passage "without exerting influence on an operation" means that the influence is not completely exerted on the operation, there may be a permissible influence. For example, there may be a case where, although an output level is somewhat lowered, the output itself is acceptable. Nevertheless, an amplifier may be provided in a control circuit to thereby compensate the lowering of the output level. Namely, it is necessary to modify the control circuit before the identification of the pattern components can be carried out.

Also, the integrated circuit production method according to the present invention comprises a step of preparing a cell of a 1-input gate, composed of a 1-input N-type transistor and a 1-input P-type transistor, as a basic cell unit in a cell library for a CMOS semiconductor device, a step of registering a cell of an N-input gate, composed of pattern components each forming a basic cell of the 1-input gate, in the cell library, and a step of carrying out an block exposure, using a block mask on which patterns are formed based on the cell library. Like this, in the present invention, the cell of the N-input gate is composed of includes the pattern components of the 1-input gates, this cell is registered in the cell library, and the block exposure is carried out, using the block mask on which a pattern is formed based on the cell library. In this case, for example, no pattern for a cell of a 2-input gate is formed on the block mask, only the pattern component for the 1-input gate no pattern is formed on the block mask. When the block exposure is carried out to form the 2-input gate, the pattern component of the 1-input gate is projected on a resist layer of a substrate by carrying out the block exposure. Since most of the patterns can be formed on the block mask, the electron beam drawing requiring a long drawing time can be suppressed to a minimum, resulting in improvement of the throughput for the pattern drawing.
Also, in the integrated circuit production method according to the present invention, if necessary, since it is possible to utilize the block mask which is formed with the plurality of blocks having different side lengths, an area restriction of the block mask can be mitigated, whereby the cell pattern components can be formed on the block mask. Even the pattern components, which could not be formed on the block mask, can be formed on the block mask as blocks. Thus, it is possible to carry out the block exposure with respect to more areas of the pattern, whereby the drawing time can be considerably improved.

### THE BEST MODE FOR EMBODYING THE INVENTION

### (First Embodiment of The Invention)

A integrated circuit design system according to a first embodiment of the present invention is explained based on Figs. 1 to 7. Fig. 1 is a block diagram showing a development flowchart according to the present embodiment, Fig. 2 is a system organization diagram of the integrated circuit design system according to the present embodiment, Fig. 3 is a constitution diagram of a common design circumstance of the integrated circuit design system according to the present embodiment, Fig. 4 is an explanatory view of a juncture processing according to the present embodiment, Fig. 5 is an explanatory view of an OPC processing according to the present embodiment, Fig. 6 is an explanatory view of a common cell library according to the present embodiment, and Fig. 7 is another explanatory view of the common cell library according to the present embodiment.

In this embodiment, the system is mainly explained, but the present invention is executed as a program which is usable in a computer. Thus, the present invention can be embodied as a form of hardware software, as a form of software, and as a combination of the software and the hardware. The program can be stored in a computer-readable memory medium, such as a hard disk, a CD-ROM, a DVD-ROM, an optical memory unit, a magnetic memory unit and so on.

The integrated circuit design system comprises a photomaskless apparatus 10 for producing an integrated circuit based on pattern information without using any photomask, a photomask apparatus 20 for producing an integrated circuit by using a photomask based on pattern information, and an integrated circuit design assistant apparatus 30 including a conversion means 31 for converting design information, prepared through the intermediary of an integration circuit function design and/or a logic design, into pattern information which satisfies both a pattern characteristic of the photomaskless apparatus 10 and a pattern characteristic of the photomask apparatus 20. The integrated circuit design assistant 30 outputs the converted pattern information to the photomaskless apparatus 10, and a trial integrated circuit is produced based on the pattern information concerned by the photomaskless apparatus 10. The trial integrated circuit is evaluated, and the pattern information concerned is modified, if necessary, to thereby prepare common pattern information. A mass production of chips is carried out by the photomask apparatus 20, using a photomask based on the common pattern information. In the integrated circuit concerned, an LSI (large Scaled IC) and so on are included.

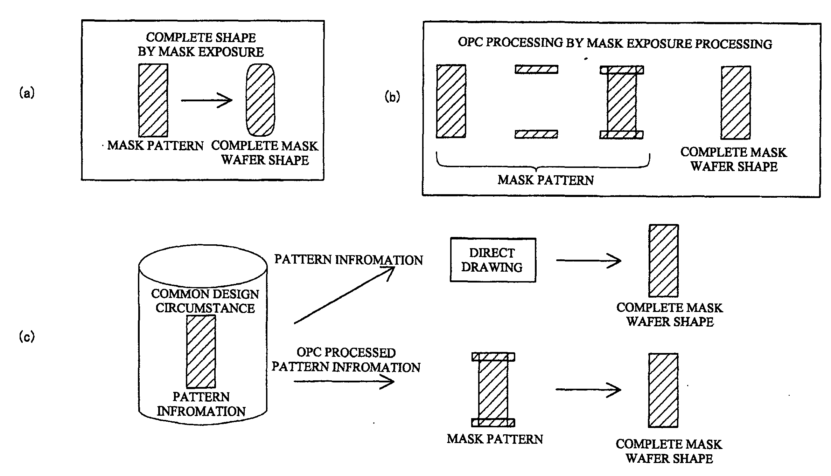

The photomask apparatus 20 comprises an optical exposure apparatus 21 for producing an integrated circuit, using a photomask based on pattern information. When an exposure process is carried out by optical exposure apparatus 21, using a photomask of a photomask pattern of Fig. 5(a), one of the pattern characteristics of the optical exposure apparatus 21 is represented by a resulting wafer-like shape of Fig. 5(a) having deformed four corners, which is derived from a mask pattern of Fig. 5(a). This is caused by a diffraction based on a wavelength of light, which is brought forth when a light used in the optical exposure apparatus passes through the photomask. For this reason, when the optical exposure apparatus is carried out, patterns for compensating the deformed corners is previously formed at the portions of the photomask which correspond to the deformed corners, so that the occurrence of the deformed corners can be eliminated to thereby obtain a desirable resulting wafer-like shape. Concretely, on the leftmost pattern shown in Fig. 5(b), the next patterns are superposed so as to define the further next pattern, and the resulting wafer-like shape is obtained by using that next pattern. Like this, the formation of compensatory patterns at an ordinary mask pattern for carrying out conversion of pattern information is called an OPC processing. On the other hand, in the photomaskless apparatus 10, there is no deformation of the corners of the pattern because no photomask is used, and thus the OPC processing for preventing the occurrence of the deformed is not carried out. To the contrary, if the OPC processing for preventing the occurrence of the deformed corners is carried out, a resulting wafer-like shape is obtained as an expected one.

The photomaskless apparatus 10 is to produce an integrated circuit based on pattern information without using any photomask, and correspond to, for example, an electron beam direct drawing apparatus 11. One of the characteristics of the electron beam direct drawing apparatus is represented by an occurrence of a juncture on forming two consecutive scanning rows due to a restriction of a scanning width of electron beam (see: Fig. 4(a)). As shown in Fig. 4(b), when the juncture occurs at a location at which a gate electrode is formed, there is a high probability that wrong matters take place, because a bad influence may be exerted on characteristics of a transistor due to the occurrence of the juncture. On the other hand, as shown in Fig. 4(c), when the juncture occurs not at the aforesaid gate electrode formation location but at a wiring line, there is merely a small probability that wrong matters take place, and thus a proper operation can be ensured, because a required accuracy of the wiring line is low. Accordingly, for the electron beam direct drawing apparatus 11, it is important to carry out the juncture processing, by which the pattern information is prepared so that the juncture does not occur at the active area. On the other hand, in the optical exposure apparatus 21, the exposure process is carried out in a lump by using the electron beam, and no scanning operation is carried out. Thus, it is unnecessary to prepare the pattern information subjected to the juncture processing, because there is no occurrence of the junctures. Note, as a substitute for the photomaskless apparatus 10, it is possible to utilize another drawing apparatus except for the electron beam direct drawing apparatus 11, for example, a laser beam direct drawing apparatus using a manner in which a direct drawing is carried out by scanning a wafer with a laser beam or a light beam in place of the electron beam. Also, yet another drawing apparatus, in which another manner except for the aforesaid manner is used, and in which an integrated circuit can produced based on pattern information, may be substituted for the photomaskless apparatus 10. Especially, recently, in view of the facts that an electron beam is susceptible to an electromagnetic wave, and that it is difficult to prepare a special resist material for the electron beam, there is a tendency toward utilizing a drawing apparatus, including a plurality of mirror devices, in which an optical drawing using is carried out by using a light beam, which has not that demerits, in place of the electron beam. This drawing apparatus also may be used as the photomaskless apparatus.

Also, since the electron beam direct drawing apparatus 11 has a very inferior throughput in comparison with the optical exposure apparatus 21, a block exposure, in which a stamp including repeated patterns is drawn with the electron beam, is used. Regarding this block exposure, one of the pattern-characteristics of the electron beam direct drawing apparatus 11 is represented by the fact that the throughput is increasingly improved as sections to be formed by the block exposure process are more increased. The block exposure has another name which is called a cell projection. This cell projection is a method in which cell units to be repeatedly used are previously formed in a block mask, and in which the block mask is repeatedly exposed.

An existent cell library for the purpose of the photomask apparatus is prepared, and pattern information, made by using the cell library for the purpose of the photomask apparatus, is utilized in the electron beam direct drawing apparatus. There is almost no cell library for the purpose of the electron beam direct drawing apparatus. Of course, since the cell library for the purpose of the photomask apparatus is not at all taken into account the block exposure of the electron beam direct drawing apparatus, a pattern component is merely designed so that a minimum pattern is obtained by keeping a minimum layout rule. Note, the minimum layout rule is defined as a minimum dimension rule for arranging the cell pattern. For example, regarding various items, such as, a source/drain, a gate, a through hole, an Al wiring line width, a minimum space of through hole gate, and so on, rules for minimum dimensions are framed every manufacturing processes. For this reason, many kinds of pattern component, which are somewhat different from each other, must be prepared. Thus, even if pattern information is prepared by using the cell library storing the many kinds of pattern component, the pattern Information is utterly unsuitable to the block exposure. The photomasks for the block exposure, which can be incorporated in the electron beam direct drawing apparatus 11, are restricted, and thus the kinds for carrying out the block exposure are restricted. Accordingly, it is impossible to carry out the block exposure by using all the patterns. For this reason, even if the electron beam direct drawing apparatus 11 is provided with the block exposure for improving the throughput, it is impossible to sufficiently obtain the advantages. In order to aims at sufficiently improving the throughput, a cell library for the purpose of the electron beam direct drawing apparatus 11 must be prepared, taking the block exposure into account. On the other hand, in the optical exposure apparatus 21, the exposure process is carried out in a lump by using the electron beam, and no scanning operation is carried out. Namely, the optical exposure apparatus exhibits the sufficient throughput.

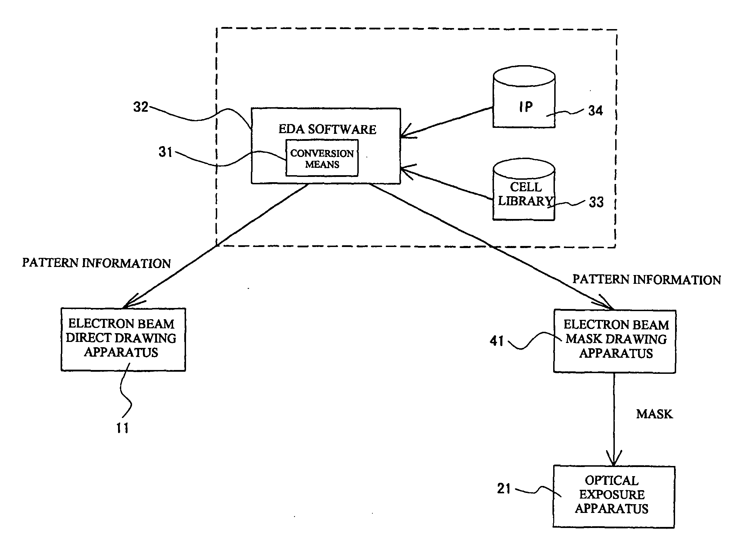

The above-mentioned integrated circuit design assistant apparatus 30 includes the conversion means 31 for converting the integrated circuit design information into the pattern information which satisfies the pattern characteristic of the photomaskless apparatus 10 and the pattern characteristic of the photomask apparatus 20, and creates a part of the design circumstance. Although the design circumstance has been already proposed in various forms, for example, it may be created by components, such as, an EDA (electronic design automation) software, an inspection software, a cell library, IP (intellectual property) 34, an OPC (optical and process correction) processing software and so on. As shown in Fig. 3, in general, a designer makes products (pattern information and so on) for every processes based on design information, using the EDA software. The IP 34, which comprises a congregation composed of multipurpose circuits, and the cell library, which comprises a congregation composed of pattern components, are usually utilized by using the EDA software. In addition to the aforesaid components, the integrated circuit design assistant apparatus 30 is provided as a component of the design circumstance, otherwise there may be a case where the integrated circuit design assistant apparatus 30 is incorporated as one of the functions of the EDA software 32.

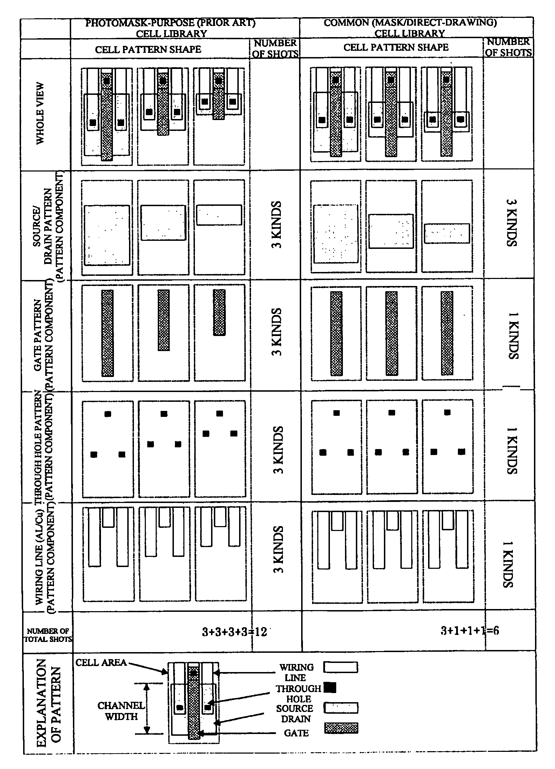

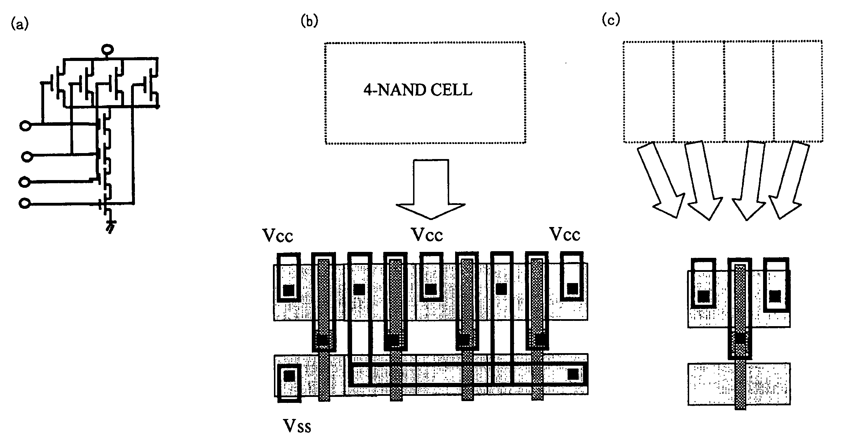

The conversion means 31 is to convert the design information into the pattern information, and the conversion is carried out, using a common cell library 33 for the purpose of both the optical exposure apparatus 21 and the electron beam direct drawing apparatus 11. The common cell library 33 is different from the conventional cell library for the purpose of the photomask apparatus 11, and is substantially identical to the cell library for the purpose of the electron beam direct drawing apparatus 11, which is taken the block exposure into account. The reason why the words "substantially identical" is used is that there may be a case where it is not said that the common cell library 33 is strictly identical to the cell library for the purpose of the electron beam direct drawing apparatus 11. Namely, this is because it is assumed that there may be a case where a pattern component must be handled as a certain different pattern due to a restriction to which the optical exposure apparatus 21 is subjected. When the common cell library 33 is used, it is presumed that the pattern information is somewhat redundant for the optical exposure apparatus 21, but this defect is very minor in comparison with a considerable improvement of the throughput obtained by the block exposure. This is because an influence, which is exerted on an integrated circuit as a whole due to a variation in a pattern size , is very small in view of the recent remarkable progress of an integration rate of a semiconductor device which is derived from a considerable miniaturization of transistors themselves. Fig. 6 shows concrete examples in which the common cell library 33 is compared with the cell library for the purpose of the photomask apparatus 20. In the row named the "WHOLE VIEW", the cell library for the purpose of the photomask apparatus 20 has three kinds of pattern figure, and also the common cell library 33 correspondingly has three kinds of pattern figure. In the "WHOLE VIEW", the pattern figures of the cell library for the purpose of the photomask apparatus 20 are compactly formed in comparison with the pattern figures of the common cell library. However, when each of the pattern figures is decomposed into the pattern components (of which each pattern figures is composed): a source/drain pattern, a gate pattern, a through hole pattern and a wiring line pattern (although these patters are shown as ones corresponding to only four layers included in a multi-layered structure for the sake of convenience of explanation, in reality, a layer-number of the multi-layered structure is from 15 to 50 in that it includes well patterns, wiring patterns and so on.), it is found that twenty two kinds of pattern component are required in the cell library for the purpose of the photomask apparatus 20, whereas only six kinds of pattern component are required in the common cell library. Like this, by reducing the kinds of pattern component, it is possible to frequently utilize the block exposure to form patterns, resulting in the improvement of the throughput. Note, in Fig. 6, only one transistor is shown as an example, but it is possible to reduce the kinds of pattern component in the common cell library in a similar manner even though a plurality of transistors are formed as cells. Also, conventionally, pattern figures per one cell are registered as a function block in the cell library. The function block is defined as a logic gate, such as an inverter, a NAND or the like. In Fig. 7, a circuit diagram (Fig. 7(a)) regarding the NAND, a pattern figure (Fig. 7(b)) registered in the cell library for the purpose of the photomask apparatus 20, and a pattern figure (Fig. 7(c)) registered in the common cell library are illustrated. Namely, regarding the pattern figure of Fig. 7(b), there is no problem because the optical exposure can be carried out in a lump by the photomask apparatus 20. However, when the pattern figure of Fig. 7(d) is drawn, as it is, by the photomaskless apparatus 10, it take the time which are from 10 to 100 times. Therefore, by using the pattern figure of Fig. 7(c), it is possible to form the pattern in a general block exposure.

Next, regarding the pattern components in the cells of the cell library, the patterns on the block mask, and the block exposure, explanations are made in detail. By decomposing the cells of the pattern figure of Fig. 7(b) into the cell pattern components, and by forming the patterns on the block mask, it is possible to carry out the block exposure. However, the cell pattern components having a low frequency in use cannot be formed on the block mask because the block mask has a finite area. In this case, as stated above, while the drawing is carried out by the photomaskless apparatus 10, the drawing based on the electron beam must be carried out with respect to the portions at which the block exposure cannot be used, resulting in consumption of much time. The drawing on the aforesaid portions exerts a large influence on the whole drawing time, and thus the whole drawing time is extended. Accordingly, in the drawing, it is necessary to carry out the block exposure on as many areas as possible, and it is preferable to form all the cell pattern components on the area of the block mask, if possible. Note, although it is demanded that a certain cell pattern component and another cell pattern component are common to each other, in this case, it is not necessarily demanded that they coincides with each other in a kind of logic gate. For example, if a pattern component on through holes for an inverter and a pattern component on through holes for a 2-input NAND is common to each other, it is possible to carry out the block exposure by using the common pattern component on the block mask. Information on a cell and information on a pattern component are correlated with each other, so that it can be recognized what pattern component a certain cell should be combined with.

Thus, among the cells of the cell library which are different from each other in a function and a capability, the same kinds of pattern component are identified with each other without altering an operation to thereby produce a cell library (as a concrete example, the identification can be carried out as the pattern components of the common cell library of Fig. 6). By carrying out the block exposure, using the block mask on which the patterns are formed based on the cell pattern components of the latter cell library, it is possible to form more pattern components on the block mask as patterns, and thus it is possible to use the block exposure at more areas, resulting in considerable reduction of the drawing time. Also, the patterns based on the cell pattern components of the cell library concerned may be formed on a block mask of a third embodiment stated later, and this block mask features a superior freedom regarding a block shape, so that a cell pattern component, which could not be formed as a pattern on a conventional block mask, is allowed to be formed on the block pattern concerned, resulting in further improvement of productivity.

In the above-mentioned identification of pattern components, for example, regarding the 4-input NAND circuit shown in Fig. 7 (b), an approach for producing a cell of the 4-input NAND circuit based on the previously produced cell of the 1-input NAND shown in Fig. 7(c) is significant (the reverse approach is also possible.). Thus, the cell pattern component of the 4-input NAND is identified with to the pattern component of the 1-input NAND, to thereby reduce the number of the pattern components in the cell library, whereby most of the pattern components can be formed as patterns on the block mask. As is being apparent from Figs. 7(b) and 7(c), it is not unnecessary to identify all the pattern components. The portions, which are different from each other, may be again left as pattern components, otherwise these portions may drawn with the electron beam. In this case, since the portions to be transferred and drawn by only the block exposure using the block mask are increased, it is possible to reduce the portions to be drawn by the electron beam, and thus the throughput can be improved in proportion to the identified portions.

Also, the aforesaid conversion means 31 carries the juncture processing to thereby produces pattern information. Conventionally, the juncture processing has been carried out with respect to the pattern information in the electron beam direct drawing apparatus 11, but the juncture processing cannot be carried out with respect to the pattern information in the optical exposure apparatus 21. This is because it is unnecessary to carry out the juncture processing in that no juncture occurs in the optical exposure apparatus 21, and because the pattern information is somewhat redundant due to the fact that the pattern components are subjected to the juncture processing.

Also, the aforesaid conversion means 31 subjects the converted pattern information to the OPC processing to thereby produce pattern information for the optical exposure apparatus 31. As of the conversions which are carried out in aforesaid common cell library 33 and the aforesaid juncture processing, the pattern information of the electron beam direct drawing apparatus 11 and the pattern information of the optical exposure apparatus 21 are identical to each other. However, after the OPC processing is carried out, the pattern information of the electron beam direct drawing apparatus 11 and the pattern information of the optical exposure apparatus 21 are not identical to each other. This is because a wrong matter takes place by carrying out the OPC processing in the electron beam direct drawing apparatus 11. Namely, when the OPC processing is carried out with respect to the electron beam direct drawing apparatus 11, as stated above, the resulting wafer-like shape is different from the expected pattern. Although the pieces of pattern information are not certainly identical to each other, an integrated circuit, which is experimentally made by the electron beam direct drawing apparatus 11 based on the pattern information not subjected to the OPC processing, is identical to an integrated circuit which is experimentally made by the optical exposure apparatus 21 based on the pattern information subjected to the OPC processing. Thus, as shown in Fig. 5(c), the pattern information not subjected to the OPC processing is output to the electron beam direct drawing apparatus 11 to thereby produce the integrated circuit, and the pattern information subjected to the OPC processing is output to the optical exposure apparatus 21 to thereby produce the integrated circuit. Like this, it is possible to obtain the resulting wafer-like shapes which are identical to each other.

Next, an operation of the integrated circuit design system of the present embodiment is explained. Note, the explanation is made provided that the integrated circuit design assistant apparatus 30 is incorporated in the EDA software 32 as a function thereof. The photomask apparatus 10 is regarded as the electron beam direct drawing apparatus 11 which is provided with a terminal other than the drawing function for converting the pattern information into drawing information, thereby being allowed to draw. The photomask apparatus 20 is regarded as the optical exposure apparatus 21. This optical exposure apparatus includes a photomask production apparatus 40 which produces a photomask for the purpose of the photomask apparatus, and the photomask production apparatus 40 is provided with a terminal for producing the photomask based on the pattern information. Further, the operation of the integrated circuit design system of the present embodiment is featured by an integrated circuit design method realized as a photomask/photomaskless fusion method wherein a photomask trial method and a photomaskless trial method are fused with each other so as to obtain both a merit of the photomask trial method allowing production of trial chips without producing photomasks and a merit of the photomaskless trial method allowing use of pieces of pattern information for a trial production as pieces of pattern information for a mass production.

First, a system design (step 1) is carried out by a customer (set maker), and an order for trial-chips with a function specification document is given to a semiconductor maker (step 2). When a design manager receives the function specification document (function diagrams, HDL, logic equations, truth-value tables) sent from the customer (set maker), usable IPs are sought by the design manager. When there is a part of the IPs which cannot be sought by the design manager, that part is suitably divided into some parts, and these parts are transferred to junior designers in charge. Each of the designers in charge sends the part of the function specification document to a logic synthesis software of the EDA software, and a provisional logic circuit (net list) is made by the logic synthesis software. The designer in charge finds out incomplete portions and defect portions in the provisional logic circuit (net list), and the provisional logic circuit (net list) is processed with a circuit diagram design software by suitably referring to the IP, to thereby complete a logic circuit (net list). Then, each of the designers make a logic simulation execute on the net list, so that the net list is suitably corrected with the circuit diagram design software of the EDA tool. After the logic circuits are completed by the respective designers, the logic circuits (net lists) are combined with each other, and a simulation is further made to be executed on the combined whole logic circuit, using a simulation software of the EDA tool. When a defect portion is found, a corresponding part of the whole logic circuit is returned to the designer. This process is carried out until the whole logic circuit is completed.
The completed logic circuit (net list) is sent to a layout design tool in which the integrated circuit design assistant apparatus of the EDA tool is functionally incorporated, and the conversion means subjects the logic circuit to the juncture processing, referring to the common cell library 33, to thereby prepare pattern information. The prepared pattern information is inspected by using a layout inspection tool of the EDA tool, and is suitably corrected by the layout inspection tool to thereby complete the pattern information. Like this, an LSI design is carried out (step 3).

The competed pattern information is output to the electron beam direct drawing apparatus 11. In the electron beam direct drawing apparatus 11, a direct drawing (or a block exposure using a block mask) is carried out on a wafer without using any photomask, whereby the wafer (shuttle) is competed (step 4), and chips on the wafer are evaluated (step 5). When the evaluated results do not satisfy the specifications, the design is started afresh, and the photomask pattern is again prepared. The design is repeatedly carried out until the evaluated results satisfy the specifications (not only the chips on the wafer are evaluated, but also the mounted chips and the packaged chips are evaluated.). When the desirable evaluation is obtained, the pattern information concerned is stored as a common pattern information. A WS (working sample), in which the chip is sealed in a package, is delivered to the customer (set maker) (step 6), and the customer (set maker) evaluates the WS (step 7). As the result of the evaluation, when it is determined by the customer (set maker) that an alteration is required, the flow proceeds to the customer system design in which an order for trial-chips is again given. As the result of the evaluation, when it is determined by the customer (set maker) that no alteration is required, an order for mass production is given to the semiconductor maker (step 8). In the semiconductor maker, by using the EDA software 32, the cell library 33, the layout rule, the IP 34 and so on, which creates the same design circumstance as mentioned above, the common pattern information, from which the order for mass production is derived, is subjected to the OPC processing by the conversion means 31, and is then output as the OPC processed pattern information to the photomask production apparatus 40. In the photomask production apparatus, a photomask is produced based on the OPC processed pattern information (step 9). A mass production is carried out by using the photomask as a mass-production photomask without correcting it (step 10). After products are manufactured, these products are delivered to the customer (set maker) (step 11).

Like this, according to the integrated circuit design system of the present embodiment, since there is provided the integrated circuit design assistance apparatus including the conversion means 31 for converting the design information, which is prepared through the integrated circuit function design and/or the logic design, into the pattern information, which satisfies both a pattern characteristic of the photomaskless apparatus 10 for producing an integrated circuit based on the pattern information without a photomask and a pattern characteristic of the photomask apparatus 20 for producing an integrated circuit by using a photomask based on the pattern information, it is possible to utilize the same pieces of pattern information in both the photomaskless apparatus 10 and the photomask apparatus 20. Also, even though the pieces of pattern information are formally different from each other, respective chips produced on wafers are at least finally identical to each other. Accordingly, the pattern information can be utilized, as it is, in an integrated circuit development using only the photomaskless apparatus 10, an integrated circuit development using only the photomask apparatus 20, and an integrated circuit development using both the photomaskless apparatus 10 and the photomask apparatus 20, and thus it is possible to utilize various development methods. Also, according to the integrated circuit design system of the present embodiment, since the conversion of the pattern information is carried out by the aforesaid conversion means 31, using the common cell library 33 comprising the congregation composed of pattern components which satisfies both the pattern characteristic of the photomaskless apparatus 10 and the pattern characteristic of the photomask apparatus 20, the pattern information of the photomaskless apparatus 10 and the pattern information of the photomask apparatus 20 are substantially identical to each other, the chips produced by the photomaskless apparatus and the photomask apparatus may be identical to each other. Especially, when the photomaskless apparatus 10 is the electron beam direct drawing apparatus 11, the design information is converted into the pattern information by using the common cell library, and thus it is possible to frequently utilize the block exposure, resulting in the improvement of the throughput. Also, according to the integrated circuit design system of the present embodiment, the integrated circuit design assistance apparatus 30 outputs the pattern information to the photomaskless apparatus 10, and the photomaskless apparatus 10 produces a trial integrated circuit based on the pattern information. Then, the trial integrated circuit is evaluated, and the common pattern information is improved, if necessary. Then, the mass production of chips is carried out by the photomask apparatus 20, using the photomask produced based on the improved common pattern information. Thus, the trial integrated circuit is produced at low cost by using the photomaskless apparatus 20 without using an expensive photomask, and is improved, if necessary, to thereby produce the trial integrated circuit which satisfies the requirements of the specifications. When the order for mass production is given, a photomask is produced without any evaluations, by only carrying out the conversion of the pattern information, from which the trial integrated circuit satisfying the requirements of the specifications is derived, and thus it is possible to immediately carry out the mass production. Usually, although it is necessary to carry out respective evaluations at a trial production stage and a mass production stage upon using the photomask apparatus 10, these evaluations are unnecessary, and thus not only can the production cost be considerably reduced, but also the development period can be shortened. Also, in the conventional photomaskless trial method of Fig. 11, after the customer designates the semiconductor maker A to thereby produce a trial integrated circuit at the trial production stage, the customer chip the semiconductor maker B to thereby carry out the mass production at the mass production stage. Namely, there is not a close relationship between the trial production stage and the mass production stage. There may be a case where the orders are given to the respective semiconductor makers, and there may be a case where the orders are consistently given to the same semiconductor marker at both the trial production stage and the mass production stage. since the same development period may be required, and since the same product chip may be obtained, the customer might select the semiconductor maker so that the whole cost is decreased. However, according to the present invention, since there is the closed relationship between the trial production stage and the mass production stage, it is possible for the semiconductor maker to attract customers, whereas the customer has the advantage that the development period is considerably shortened. Also, according to the integrated circuit design system of the present embodiment, the aforesaid conversion means carries out the conversion of the pattern information so that the juncture, caused by the width of the electron beam of the electron beam direct drawing apparatus, departs from the active area. Thus, although the pattern information concerned must be subjected to the juncture processing, which is unnecessary for the photomask apparatus 20, not only can the chips be inexpensively produced by the photomaskless apparatus 10, but also the photomask can be produced based on the pattern information which is derived from the well-evaluated chip. Accordingly, it is possible to immediately carry out the mass production, using the aforesaid photomask as it is. Thus, not only can the production cost be reduced, but also the development period can be shortened. Also, according to the integrated circuit design system of the present embodiment, the pattern information converted by the aforesaid conversion means is further converted into the OPC processed pattern information for the purpose of the photomask apparatus, and thus the OPC processed pattern information is not identical to the pattern information which is derived from the well-evaluated chip. Nevertheless, since the chip, which is produced by using the photomask produced based on the OPC processed pattern information, is identical to the well-evaluated chip, it is possible to carry out the mass production without any evaluations.

Note, in the integrated circuit design system of the present embodiment, although the pattern information is output to the electron beam direct drawing apparatus or the optical exposure apparatus as it is, the pattern information may be formally converted into a form which can be recognized by the electron beam direct drawing apparatus or the optical exposure apparatus, prior to the outputting of the pattern information.
Also, in the integrated circuit design system of the present embodiment, although the explanation is made provided that the integrated circuit design assistant apparatus is incorporated in the EDA tool as a function thereof, the integrated circuit design assistant apparatus may be incorporated as one of the components forming the design circumstance. For example, in a case where there is the DEA tool for converting the design information into the pattern information, the integrated circuit design assistant apparatus carries out a reading of the common cell library 33, a juncture processing and an OPC processing in accordance with demands of the EDA tool. Also, the integrated circuit design assistant apparatus 30 may be composed of an apparatus for reading the common cell library 33, an apparatus for carrying out the juncture processing, and an apparatus for carrying out the OPC processing.

Also, in the integrated circuit design system of the present embodiment, although the photomask is produced by the photomask production apparatus 40, the electron beam direct drawing apparatus 11 may be provided with the functions of both the photomaskless apparatus 10 and the photomask production apparatus 40, because an apparatus for producing a photomask is usually formed as an electron beam photomask production apparatus 41.
Also, in the integrated circuit design system of the present embodiment, although the conversion of the pattern information is carried out so that the juncture departs from the active area, an addition of active areas to the pattern information (maskless prooess)and a deletion of active areas from the pattern information (mask process) may be carried out by a design tool software.

### (Second Embodiment of The Invention)

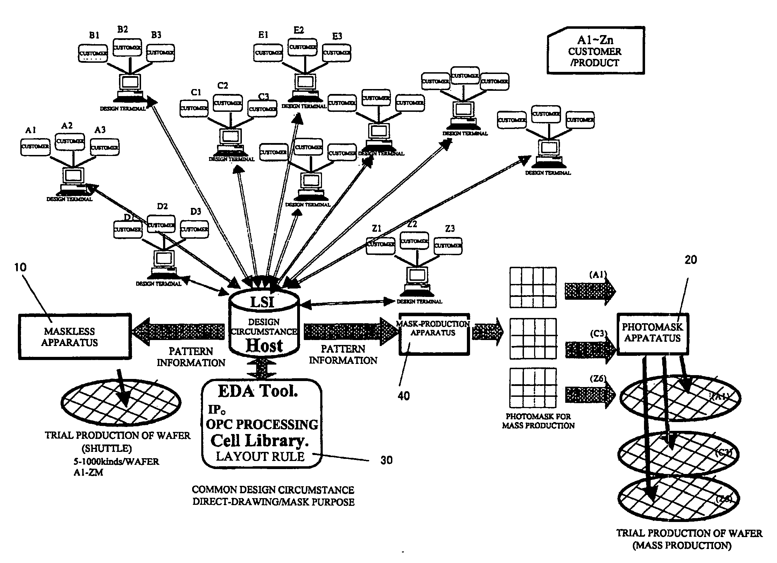

Based on Fig. 8, an integrated circuit design system according to a second embodiment of the present invention is explained. Fig. 8 is a system organization diagram of the present embodiment.
The integrated circuit design system of the present embodiment is arranged in a similar manner to the integrated circuit design system of the aforesaid first embodiment, and is further featured by the fact that, firstly, in the photomaskless 10, trial chips are produced on the same wafer based on pieces of pattern information by using a transfer process, without using any photomask, and by the fact that, secondary, a mass production of the chips is carried out by the photomask apparatus, using a photomask produced based on pieces of common pattern information which are concerned with respective chips assigned on the aforesaid same wafer in accordance with external demands.

An operation of the integrated circuit design system of the present embodiment is explained with reference to the operational explanation of the first embodiment. The aforesaid steps 1 through 3 are similarly executed, and the pieces of pattern information are prepared. Then, the pieces of pattern information are output to the electron beam direct drawing apparatus 11, and a plurality of chips are formed on the aforesaid same wafer by carrying out a direct drawing without using any photomasks, resulting in completion of the wafer (shuttle). The chips on the same wafer are evaluated. When desirable chips satisfying the specifications cannot be obtained, the design is started afresh, and the photomask pattern is again prepared. The design is repeatedly carried out until the evaluated results satisfy the specifications (not only the chips on the wafer are evaluated, but also the mounted chips and the packaged chips are evaluated.). When the desirable evaluation is obtained, the pieces of pattern information concerned is stored as pieces of common pattern information. WSs (working samples), in which the chips are sealed in packages, are delivered to the respective customers (set makers), and each of the customers (set makers) evaluates the WS. As the result of the evaluation, when it is determined by the customer (set maker) that an alteration is required, the flow proceeds to the customer system design in which an order for trial-chips is again given. As the result of the evaluation, when it is determined by the customer (set maker) that no alteration is required, an order for mass production is given to the semiconductor maker. In the semiconductor maker, by using the EDA software 32, the cell library 33, the layout rule, the IP 34 and so on, which creates the same design circumstance as mentioned above, the common pattern information, from which the order for mass production is derived, is subjected to the OPC processing by the conversion means 31, and is then output as the OPC processed pattern information to the photomask production apparatus 40. In the photomask production apparatus, a photomask is produced based on the OPC processed pattern information. A mass production is carried out by using the photomask as a mass-production photomask without correcting it. After products are manufactured, these products are delivered to the customer.

Like this, according to the integrated circuit design system of the present embodiment, since the photomaskless apparatus 10 produces the trial chips on the same wafer based on the pieces of pattern information without using any photomask, it is possible to form plural kinds of chip on the same wafer by the photomaskless apparatus 10. Namely, since plural kinds of chips, which are allocated for some manufactures, can be formed on the expensive wafer, it is possible to decrease a chip production cost. For example, when one wafer is priced at 1,000,000 yen, and when the wafer is shared with 10 manufactures (10 kinds of chip), resulting in decreasing to 100,000 yen. Usually, it is possible to form from 500 to 1,000 chips from one wafer, and thus the wafer can be shared with the plurality of manufactures because an enough number of the same kind of trail chip is from 10 to 20, to thereby allowing the decrease in the chip production cost. Note, in the photomask apparatus 20, the kinds of chip which can be formed on the same wafer is limited to a range from 4 to 6 (due to a dimensional restriction of a photomask). Also, according to the integrated circuit design system of the present embodiment, the mass production of the chips is carried out by the photomask apparatus, using the photomask produced based on the pieces of common pattern information which are concerned with the respective chips assigned on the same wafer in accordance with the external demands. Thus, as long as the pieces of pattern information are prepared, it is possible to automatically carry out the mass production of desirable chips in accordance with the external demands without being substantially assisted by persons. Also, as shown in Fig. 8, the present integrated circuit design system can be in data-communication with design terminals of many customers, and thus it is possible to simultaneously contract with worldwide customers for the developments, to thereby realize the development system from the trial production process to the mass production process throughout. Also, since the mass production can be carried out without being substantially assisted by the persons, it is possible to easily determine a delivery date, and, by a customer's referring to a semiconductor maker, it is possible to rapidly obtain a response on a reliable delivery date.

### (Third Embodiment of The Invention)

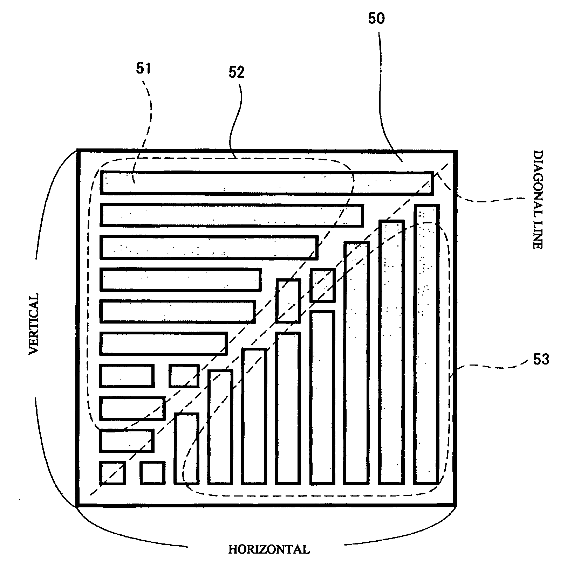

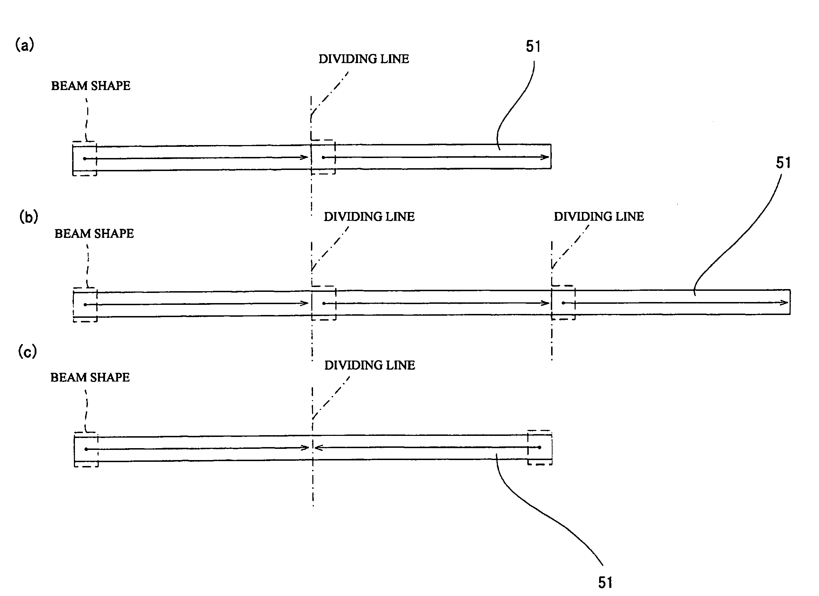

Based on Fig. 9 or 10, an integrated circuit design system according to a third embodiment of the present invention is explained.
The integrated circuit design system of the present embodiment is arranged in a similar manner to the integrated circuit design system of the aforesaid first embodiment, and there is a difference in an arrangement of the block mask 50 used in the block exposure.

Fig. 9 is a plan view of a block mask of the present embodiment. The aforesaid block mask 50 is different from a conventional block mask having blocks 51 each of which is formed as a square, and, for example, is formed with a plurality of blocks 51, in which sides defining the blocks have different lengths, as shown in Fig. 9. It is possible to obtain a considerable freedom by merely mingling the elongatedly rectangular blocks with the square blocks. Further, it is possible to freely define patterns in the block 51 by varying the lengths of the side defining the respective blocks. Conventionally, for the purpose of carrying out the block exposure by using utilizing a certain pattern in the block exposure, although it has been tried that the pattern is defined in the block 51, there was a case where an exposure of the pattern could not be carried out with using the block exposure due to restriction of a block size, and thus there was nothing except for carrying out a drawing with using an electron beam. Also, when a pattern frequently used could not be set in one block 51, the pattern was divided into a plurality of patterns to allow them to be formed in block mask. In this case, not only the design is troublesome due to the division of the pattern, but also it is necessary to carry out a highly accurate positioning process in that a block exposure must be carried out many times to thereby obtain one pattern. In view of these circumstances, a main concept of the present embodiment aims at setting sizes of blocks with a certain degree of freedom in accordance with a pattern.

For example, as shown in Fig. 9, in the blocks 51 of the block mask 50, the short sides of all the blocks 51 on the block mask 50 have the same length, but the long sides of them are different from each other. It is possible to carry out the block exposure by either shaping a width of an electron beam corresponding to the long side of a block or scanning the block with the electron beam, without varying a width of the electron beam corresponding to the short side of the block (the shaping and the scanning may be combined with each other), and thus the block exposure can be rapidly achieved due to the width of the electron beam corresponding to the short side of the block being not varied. In a case where a plurality of electron beams, the more the number of the electron beams, the more the rapidity.

Also, the block mask 50 of Fig. 9 includes a vertically-lengthened block area 53 in which the blocks are arranged so that the long sides of the blocks extend in a vertical direction of the block mask 50, and a horizontally-lengthened block area 52 in which the blocks are arranged so that the long sides of the blocks extend in a horizontal direction of the block mask 50. Like this, by dividing the block mask into the areas, when the block exposure is carried out with respect to one of the areas, the electron beam scanning can be executed in one direction to thereby enhance a rapidity of the electron beam scanning, and the formation of the blocks 51 on the block mask 50 can be easily carried out. Also, not only can the blocks 51 be arranged at a high density, but also the aforesaid area-division is applicable to actual patterns to thereby obtain a high applicability in that the patterns are usually formed so as to be extended in the vertical and horizontal directions. Further, the diagonal line of the block mask 50 defines the boundary between the vertically-lengthened block area 53 and the horizontally-lengthened block area 52, and thus the space on the block mask 50 can be usefully and effectively utilized.

Also, as shown in Fig. 9, for example, in the horizontally-lengthened block area 52, after a scanning of the uppermost block 51 is carried out, a continuous exposure to the second block 51 can be substantially carried out, and further continuous exposures can be substantially carried out in order in a similar manner. Also, according to the patterns as shown in Figs. 9, it is possible to effectively carry out a block exposure by scanning rightward the uppermost block 51 with the electron beam in the horizontally-lengthened block area 52, by scanning downward the rightmost block 51 with the electron beam in the vertically-lengthened block area 53, by scanning upward the second block 51 from the rightmost one with the electron beam in the vertically-lengthened block area 53, by scanning leftward the second block 51 from the uppermost one in the horizontally-lengthened block area 52, and by executing the electron beam scanning in a similar manner. When these electron beam scannings are carried out, it is necessary to take an order of the blocks 51 into account before the actual pattern can be effectually drawn by the electron beam scannings. Also, the electron beam scannings are usually executed by moving the block mask.

In the present embodiment, there is provided a deflector (not shown, but illustrated in Fig. 13) by which a shape of the electron beam emitted during the block exposure is deformed into a given rectangle. The deflector functions to deflect the electron beam by using an electric field or a magnetic field. With the provision of the deflector, it is possible to properly carry out the exposure with respect to the block mask 50, which has the blocks featuring the different shapes, as stated in the present embodiment. Also, this deflector may be associated with a lens, a shaping aperture and so on so as to define a beam-shaping deflector system, and it is possible to optionally shape the electron beam by using the beam-shaping deflector system.

When a pattern is formed, there is a case where the block exposure is repeatedly carried out with respect to the same block 51. In this case, it is possible to carrying out the block exposure with a plurality of electron beams which are arranged in the longitudinal direction of the block concerned, resulting in achievement of a rapid exposure. When this block exposure is carried out, it is possible to complete the block exposure in the most rapid manner by deflecting the electron beams by the same distance for the exposure. As a more preferable method, there is a method in which the block 51 concerned is virtually divided at regular intervals into sections at the number of the electron beams used, and in which the divided sections are scanned with the respective electron beams in the same direction. According to this method, it is possible to shorten the scanning distance by the number of the electron beams, resulting in achievement of the rapid block exposure. Concretely, as shown in Fig. 10(a), when there is a certain block 51, it is divided into sections by drawing a virtual dividing line, and the divided sections are scanned with respective electron beam to thereby form a pattern. In reality, the length of the long side of the block is divided by the number of the electron beams without drawing the dividing line, and the divided lengths, each of which corresponds to the quotient, are scanned with the respective electron beams. Also, it is possible to determine the initial positions of the electron beams by adding respective products, obtained by multiplying the quotient by integers, to the original. Fig. 10(b) shows an example of scanning, in which an exposure is carried out by using three electron beams. In Fig. 10(c), since the electron beam scannings are carried out in the opposed directions, it is necessary to deflect the electron beams themselves (In Figs. 10(a) and (b), since the scannings are carried out in the same direction, they can be achieved by moving the block mask 50 itself).

Like this, in the integrated circuit design system of the present embodiment, the time for producing trial chips by the photomaskless apparatus 10 can be considerably shortened by using aforesaid block mask 50. Namely, since it is possible to carry out the production of the trial chips during a short period, and since it is possible to carry out a mass production of chips by using a photomask based on a common pattern information after a well-evaluation is obtained from the customer, it is possible not only to meet the customer's time demand, and a total production cost can be reduced.
Note, in the integrated circuit design system of the present embodiment, except for some exceptional and specific patterns, a pattern is usually featured by a multiple of the minimum wiring pitch unit. Thus, due to the fact that the long and short sides of each of the blocks 51 of the block mask 50 are featured by the multiple of the minimum wiring pitch unit, it is possible to orderly arrange the blocks 51 on the block mask 50 (in a case where the lengths of the blocks 51 could be more freely determined than needed, an arrangement of the blocks 51 was rather complicated.). Also, it is easy to carry out the shaping of the electron beam and the beam scanning due to the fact that the blocks 51 are at all times featured by a multiple of a certain unit. In a more preferable embodiment, spaces between the blocks are featured by the multiple of the minimum wiring pitch unit. In this embodiment, although the blocks are featured by the multiple of the minimum wring pitch unit, it is possible to utilize another length as a unit. Further, it is possible to utilize a multiple of 1/n (n is an integer) for the multiple of the minimum wiring pitch unit.

Although the embodiments of the present invention are explained hereinbefore, a technical scope of the present invention is not limited to only the aforesaid embodiments. it is possible to make various changes and modifications to the aforesaid embodiments, and it is apparent from the description of the claims that the modified embodiments and the improved embodiments fall in within the technical scope of the present invention.

### (Additional Note 1)

An integrated circuit design assistance apparatus characterized by a conversion means for converting design information, prepared through the intermediary of an integration circuit function design and/or a logic design, into pattern information which satisfies both a pattern characteristic of a photomaskless apparatus for producing an integrated circuit based on pattern information without using a photomask and a pattern characteristic of a photomask apparatus for producing an integrated circuit by using a photomask based on pattern information.

### (Additional Note 2)

The integrated circuit design assistance apparatus as set forth in Additional Note 1, characterized in that the aforesaid conversion means carries out the conversion of the design information of the pattern information by using a cell library, which comprises a congregation composed of pattern components which satisfies the pattern characteristic of the photomaskless apparatus and the pattern characteristic of the photomask apparatus.

### (Additional Note 3)

An integrated circuit design system comprising: an integrated circuit design assistance apparatus as set forth in Additional Note 1 or 2; the aforesaid photomaskless apparatus; and the aforesaid photomask apparatus, characterized by the fact that the aforesaid integrated circuit design assistance apparatus outputs either pattern information or similar pattern information, allowed to be input to the photomaskless apparatus, to the photomaskless apparatus, by the fact that the photomaskless apparatus produces a trial integrated circuit based on either the pattern information or the similar pattern information, by the fact that the trial integrated circuit is evaluated to prepare common pattern information, with the common pattern information being improved, if necessary, and by the fact that a mass production of chips is carried out by the photomask apparatus, using a photomask based on the common pattern information.

### BRIEF EXPLANATIONS OF DRAWINGS

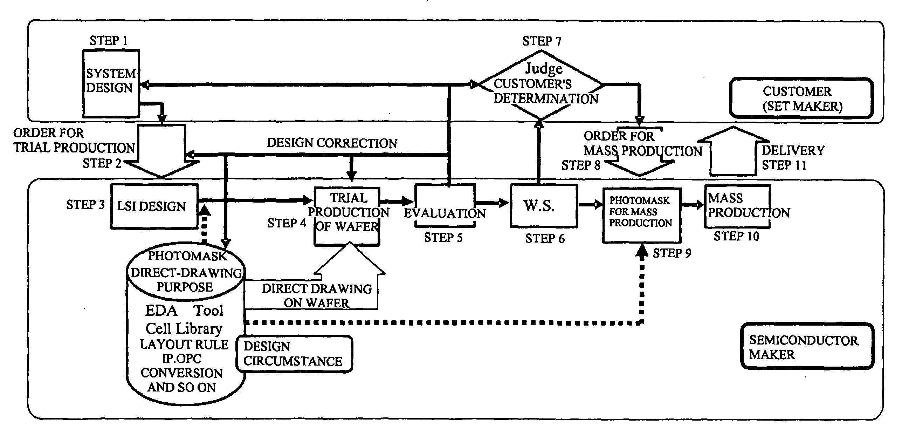

[Fig. 1] is a block diagram showing a development flowchart according to the first embodiment of the present invention.

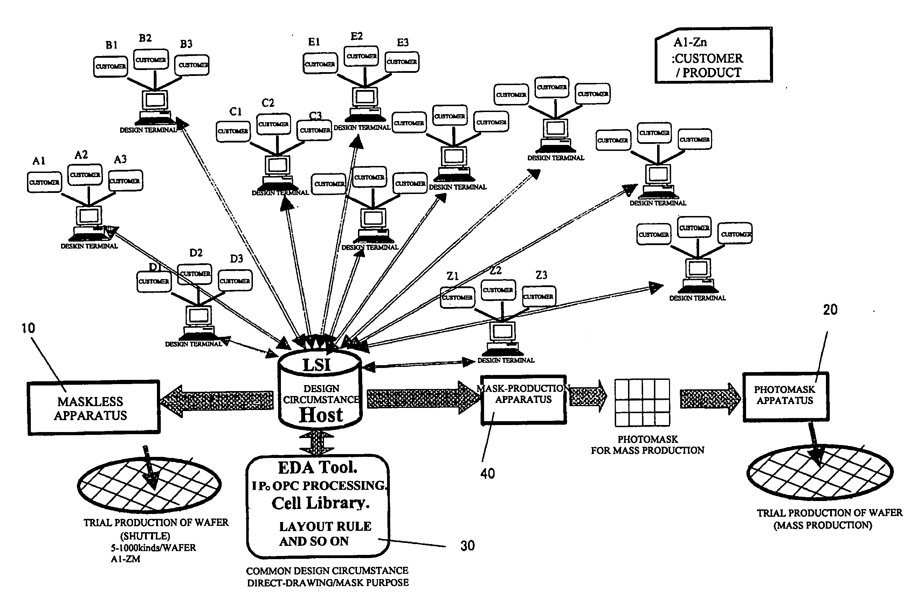

[Fig. 2] is a system organization diagram of an integrated circuit design system according to the first embodiment of the present invention.
[Fig. 3] is a constitution diagram of a common design circumstance of the integrated circuit design system according to the first embodiment of the present invention.
[Fig. 4] is an explanatory view of a juncture processing according to the first embodiment of the present invention.
[Fig. 5] is an explanatory view of an OPC processing according to the first embodiment of the present invention.
[Fig. 6] is an explanatory view of a common cell library according to the first embodiment of the present invention.
[Fig. 7] is another explanatory view of the common cell library according to the first embodiment of the present invention.
[Fig. 8] is a system organization diagram of an integrated circuit design system according to the second embodiment of the present invention.
[Fig. 9] is a plan view of a block mask according to the third embodiment of the present invention.
[Fig. 10] is an explanatory view of a plural-beam scanning according to the third embodiment of the present invention.
[Fig. 11] is a block diagram showing a development flowchart of a conventional photomask trial method.
[Fig. 12] is a block diagram showing a development flowchart of a conventional photomaskless trial method.
[Fig. 13] is both an operative explanatory view of a direct drawing apparatus using a conventional block mask and a plan view of a block mask.

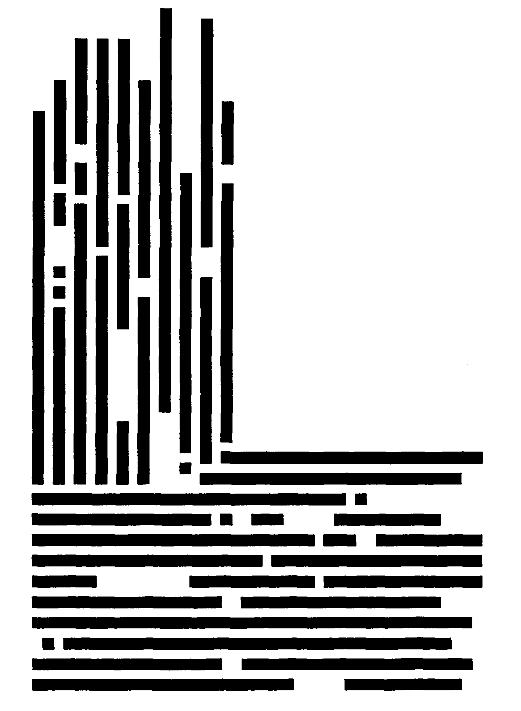

[Fig. 14] is a partial plan view of a general LSI wiring pattern.

### EXPLANATION OF REFERENCES

- 10: Photomaskless Apparatus
- 11: Electron Beam Direct Drawing Apparatus
- 20: Photomask Apparatus
- 21: Optical Exposure Apparatus
- 30: Integrated Circuit Design Assistance Apparatus
- 31: Conversion Means
- 32: EDA Soft
- 33: Double-Purpose Cell Library
- 34: IP
- 40: Photomask Production Apparatus
- 41: Electron Beam Photomask Drawing Apparatus
- 50: Block Mask
- 51: Block
- 52: Laterally-Lengthened Block Area
- 53: Longitudinally-Lengthened Block
- 101: Beam
- 102: Slit
- 103: Deflector
- 104: Block Mask
- 105: Wafer
- 106: Block

## Claims

1. An integrated circuit production method **characterized by**: a step of producing a trial integrated circuit based on pattern information for a trial production, without using a photomask, under a common design circumstance which can be utilized in both a photomaskless step of producing an integrated circuit based on pattern information without using a photomask and a photomask step of producing an integrated circuit based on pattern information with using a photomask, with the pattern information for the trial production complying with both the photomaskless step and the photomask step; a step of preparing a common pattern information by evaluating the trial integrated circuit and by improving, if necessary, the pattern information for the trial production in accordance with results of the evaluation; and a step of producing a photomask for a mass production by carrying out a formal conversion of the common pattern information, if necessary, without improving the common pattern information.

2. The integrated circuit production method as set forth in claim 1, **characterized in that** said common design circumstance is constituted as a design circumstance, including design tools, such as, an EDA (electronic design automation) software, an inspection software, a cell library, IP (intellectual property), an OPC (optical and process correction) processing software and so on necessary for an integrated circuit production, so as to be commonly utilized in both said photomaskless step and said photomask step.

3. The integrated circuit production method as set forth in claim 1, **characterized in that** said trial integrated circuit is produced on the same wafer based on the pattern information which is featured by different integrated circuits, integrated circuits having the same functions and parameters for requirements, or a combination of some of these integrated circuits, without using the photomask.

4. The integrated circuit production method as set forth in claim 3, **characterized in that** a mass production of chips is carried out by the photomask apparatus, using a photomask which is produced based on pieces of common pattern information which are concerned with respective chips assigned on the same wafer in accordance with external demands.

5. An integrated circuit design assistance program **characterized in that** a computer functions as a conversion means for converting design information, prepared through the intermediary of an integration circuit function design and/or a logic design, into pattern information which satisfies both a pattern characteristic of a photomaskless apparatus for producing an integrated circuit based on pattern information without using a photomask and a pattern characteristic of a photomask apparatus for producing an integrated circuit by using a photomask based on pattern information.

6. The integrated circuit design assistance program as set forth in claim 5, **characterized in that** said conversion means carries out the conversion of the design information into the pattern information by using a cell library, which comprises a congregation composed of pattern components which satisfies both the pattern characteristic of the photomaskless apparatus and the pattern characteristic of the photomask apparatus.

7. An integrated circuit design assistance apparatus **characterized by** a conversion means for converting design information, prepared through the intermediary of an integration circuit function design and/or a logic design, into pattern information which satisfies both a pattern characteristic of a photomaskless apparatus for producing an integrated circuit based on pattern information without using a photomask and a pattern characteristic of a photomask apparatus for producing an integrated circuit by using a photomask based on pattern information.

8. The integrated circuit design assistance apparatus as set forth in claim 5, **characterized in that** said conversion means carries out the conversion of the design information of the pattern information by using a cell library, which comprises a congregation composed of pattern components which satisfies the pattern characteristic of the photomaskless apparatus and the pattern characteristic of the photomask apparatus.

9. An integrated circuit design system comprising: either an integrated circuit design assistance apparatus obtained by installing the integrated circuit design assistance program of claim 5 or 6 in a computer or an integrated circuit design assistance apparatus as set forth in claim 7 or 8; said photomaskless apparatus; and said photomask apparatus,
**characterized by** the fact that said integrated circuit design assistance apparatus outputs either pattern information or similar pattern information, allowed to be input to the photomaskless apparatus, to the photomaskless apparatus, by the fact that the photomaskless apparatus produces a trial integrated circuit based on either the pattern information or the similar pattern information, by the fact that the trial integrated circuit is evaluated to prepare common pattern information, with the common pattern information being improved, if necessary, and by the fact that a mass production of chips is carried out by the photomask apparatus, using a photomask based on the common pattern information.

10. The integrated circuit design system as set forth in claim 9, **characterized in that** said conversion means carries out the conversion of the design information into the pattern information so that a juncture, caused by a width of an electron beam of an electron beam direct drawing apparatus, departs from an active area.

11. The integrated circuit design system as set forth in claim 9, **characterized in that** said conversion means further converts the converted pattern information into pattern information subjected to an OPC processing for the photomask apparatus.

12. The integrated circuit design system as set forth in claim 9, **characterized in that** said photomaskless apparatus produces trial integrated circuits on the same wafer based on either pieces of pattern information or similar pieces of pattern information allowed to be input to the photomaskless apparatus.

13. The integrated circuit design system as set forth in claim 12, **characterized in that** the mass production of the chips is carried out by the photomask apparatus, using the photomask which are produced based on pieces of common pattern information which are concerned with respective chips assigned on the same wafer in accordance with external demands.

14. A block mask used in a block exposure carried out by a photomaskless apparatus for producing an integrated circuit without using a photomask, **characterized in that** the block mask is formed with a plurality of blocks, sides of which have different lengths.

15. A block mask used in a block exposure carried out by a photomaskless apparatus for producing an integrated circuit without using a photomask, **characterized in that** the block mask is formed with a plurality of rectangular blocks, sizes of which are different from each other.

16. The block mask as set forth in claim 14 or 15, **characterized in that**, when each of the blocks is shaped as a rectangular block, a long side and/or a short side of the rectangular block have lengths featured by a multiple of the minimum wiring pitch unit.

17. The block mask as set forth in claim 14 or 15, **characterized in that** short sides of the blocks have the same length, and long sides of the blocks have different lengths.

18. The block mask as set forth in claim 14 or 15, **characterized in that** the block mask has a vertically-lengthened block area in which the blocks are arranged so that the long sides of the blocks extend in a vertical direction of the block mask, and a horizontally-lengthened block area in which the blocks are arranged so that the long sides of the blocks extend in a horizontal direction of the block mask.

19. A photomaskless apparatus using a block mask as set forth in claim 14 or 15, **characterized by** a means for deforming a shape of beam, which is emitted during a block exposure, into either an elongatedly rectangular shape or an elongatedly elliptic shape.

20. A photomaskless apparatus using a block mask as set forth in claim 14 or 15, **characterized in that** a block is scanned with an emitted beam during an block exposure, while a shape of the beam is maintained.

21. A photomaskless apparatus using a block mask as set forth in claim 14 or 15, **characterized in that** a block is irradiated with a plurality of beams which are arranged in a longitudinal direction of the block during an block exposure.

22. A photomaskless apparatus using the block mask, as set forth in claim 21, **characterized in that** the block is divided at regular intervals into sections at the number of beams which are longitudinally emitted, and the divided sections are irradiated and scanned with the respective beams.

23. An integrated circuit production method **characterized by**: a step of producing cells in which pattern components corresponding to the same exposure step are identified to each other among cells of a cell library which are different from each other in a function and a capability, without exerting influence on an operation; a step of registering the produced cells in the cell library; and a step of carrying out a block exposure, using a block mask on which patterns are formed based on the cell library.

24. An integrated circuit production method **characterized by**; a step of preparing a cell of a 1-input gate, composed of a 1-input N-type transistor and a 1-input P-type transistor, as a basic cell unit in a cell library for a CMOS semiconductor device; a step of registering a cell of an N-input gate, composed of pattern components each forming a basic cell of the 1-input gate, in the cell library; and a step of carrying out an block exposure, using a block mask on which patterns are formed based on the cell library.

25. The integrated circuit production method as set forth in claim 1, **characterized by**: a step of producing cells in which pattern components corresponding to the same exposure step are identified to each other among cells of a cell library which are different from each other in a function and a capability, without exerting influence on an operation; a step of registering the produced cells in the cell library; and a step of carrying out a block exposure, using a block mask on which patterns are formed based on the cell library.

26. The integrated circuit production method as set forth in any one of claims 23 through 25, **characterized in that** the block exposure is carried out, using the block mask as set forth in claim 14 or 15.

## Amended claims

### Amended claims under Art. 19.1 PCT

**8.** (amended) The integrated circuit design assistance apparatus as set forth in claim 7, **characterized in that** said conversion means carries out the conversion of the design information of the pattern information by using a cell library, which comprises a congregation composed of pattern components which satisfies the pattern characteristic of the photomaskless apparatus and the pattern characteristic of the photomask apparatus.
